# EUROPEAN PATENT APPLICATION

(11) **EP 4 274 393 A1**
(43) Date of publication of application: **08.11.2023**
(21) Application number: 22172169.9
(22) Date of filing: 06.05.2022
(51) Int. Cl.: H05K 1/14, H05K 3/46

(54) **COMPONENT CARRIER INTERCONNECTION AND MANUFACTURING METHOD**

(71) Applicant: AT & S Austria Technologie & Systemtechnik Aktiengesellschaft, 8700 Leoben-Hinterberg (AT)
(72) Inventor: Ifis, Abderrazzaq, 8700 Leoben (AT); Riegler, Eva, 8600 Bruck an der Mur (AT); Opitz, Reinhard, 8700 Leoben (AT)
(74) Representative: Donatello, Daniele

(57) **Abstract**

It is described a component carrier assembly (100), comprising:
i) a first component carrier (101) comprising at least one first electrically insulating layer structure (1012) and/or at least one first electrically conductive layer structure (1011);
ii) a second component carrier (102), comprising at least one second electrically insulating layer structure (1022) and/or at least one second electrically conductive layer structure (1021),
wherein the first component carrier (101) and the second component carrier (102) are stacked;
iii) an adhesive conductive paste (103) arranged between the first component carrier (101) and the second component carrier (102); and iv) at least an elongated mechanical fastening element (105),
wherein the fastening element (105) at least partially extends through the first component carrier (101) and the second component carrier (102), and wherein the fastening element (105) is configured to fix the first component carrier (101) and the second component carrier (102) together.

## Description

### Field of the Invention

The invention relates to a component carrier assembly, a method of manufacturing the component carrier assembly, and a use of an elongated mechanical fastening element to fix together a stack of component carriers in a component carrier assembly.

Thus, the invention may relate to the technical field of component carriers such as printed circuit boards or IC substrates.

### Technical Background

In the context of growing product functionalities of component carriers equipped with one or more electronic components and increasing miniaturization of such electronic components as well as a rising number of electronic components to be mounted on the component carriers such as printed circuit boards, increasingly more powerful array-like components or packages having several electronic components or component carriers are being employed. To connect such component carriers with each other to form a component carrier assembly, different interconnection systems are known in the prior-art.

In particular, it is known, from the prior-art, to use so-called Z-interconnections using an adhesive conductive paste arranged between two component carriers stacked together in a vertical (z) direction and then to press the panels by means of a hot-press lamination process, which is adjusted to the material of the component carriers being pressed together.

According to such method, however, the component carriers are not fixed together before the hot-press lamination, so that warpage and a deteriorated material flow/dynamics can emerge, thus causing an unstable Z-interconnection in the finished component carrier assembly.

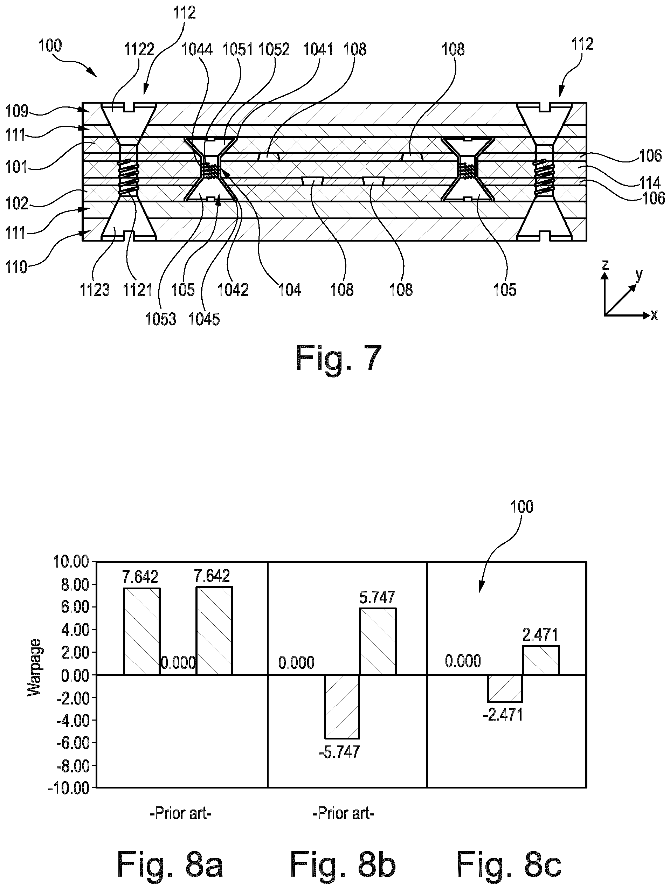

**Figures 8a** and **8b** show the warpage distribution **(****Figure 8a****)** and the total warpage **(****Figure 8b****)** of a first circuit board, and a second circuit board that are fixed together by using an adhesive conductive paste.

### Summary of the Invention

There may be a need to provide an interconnection (in particular along the z-direction) between at least two component carriers, forming a component carrier assembly, in an efficient, reliable, and robust manner.

In order to achieve the object defined above, a component carrier assembly, a method of manufacturing the component carrier assembly, and a use according to the independent claims are provided. The dependent claims describe advantageous embodiments.

According to a first aspect of the present invention, a component carrier assembly is provided. The component carrier assembly comprises a first component carrier, a second component carrier and at least one elongated mechanical fastening element. The first component carrier comprises at least one first electrically insulating layer structure and/or at least one first electrically conductive layer structure. The second component carrier comprises at least one second electrically insulating layer structure and/or at least one second electrically conductive layer structure. The first component carrier and the second component carrier are stacked. An adhesive conductive paste is arranged between the first component carrier and the second component carrier. The fastening element extends at least partially through the first component carrier and the second component carrier and is configured to fix the first component carrier and the second component carrier together.

According to a second aspect of the invention, a method of manufacturing a component carrier assembly is provided. The method comprises a first step of providing a first component carrier, comprising at least one first electrically insulating layer structure and/or at least one first electrically conductive layer structure, and a second component carrier, comprising at least one second electrically insulating layer structure and/or at least one second electrically conductive layer structure. The method comprises a second step of arranging an adhesive conductive paste between the first component carrier and the second component carrier. The method comprises a third step of stacking the first component carrier and the second component carrier. The method comprises a fourth step of fixing the first component carrier and the second component carrier together by providing an elongated mechanical fastening element extending at least partially through the first component carrier and the second component carrier.

According to a third aspect of the invention, the use of an elongated mechanical fastening element to fix together a stack of component carriers, that are connected via adhesive conductive paste, along the z-direction, is provided.

In the context of this document, the term "adhesive conductive paste" may in particular refer to any material that is electrically conductive and suitable to (at least partially) adhere two pieces (for example component carriers) together, such as conductive glue. In an example, the adhesive conductive paste comprises a sintering paste.

In the context of the present document, an "elongated mechanical fastening element" may be a fixture element that is suitable for connecting together two or more component carriers. An "elongated mechanical fastening element" is also referred to as "fastening element" in the present document. The fastening element may form/establish a permanent or a reversible mechanical connection between the at least two component carriers. The elongated mechanical fastening element may comprise a metal or a non-metal material. In an embodiment, the elongated mechanical fastening element may comprise a head (diameter variation) like a screw. In another embodiment, the elongated mechanical fastening element may comprise a similar diameter during the whole length.

In the context of this document, the z-direction may be the direction of minimal extension of a component carrier or of a layer structure (i.e. perpendicular to the directions of main extension along the x- and y-axes).

In the context of the present document, when two layers or two component carriers are stacked, they may be put on top of each other along the z-direction.

In the context of the present document, the stacking direction may therefore be considered as the z-direction.

According to an exemplary embodiment, the invention may be based on the idea that an efficient, reliable, and robust interconnection between at least two component carriers may be achieved, when a fastening element is provided for fixing the two component carriers together in addition to the application of adhesive conductive paste. In such a way it may be possible to compensate irregularities at the surfaces of the at least two component carriers in stacking direction. Also, the fastening element may release the interconnecting vias in the stacking direction from extreme loading during the manufacturing of the component carrier assembly.

Furthermore, the described design may provide at least some of the following advantages: stabilize the interconnection between component carriers, improve the performance of the Z-interconnection, allow a higher number of component carriers and/or layers to be stacked together, reduce the issues caused by a poor panel flatness, allow a higher miniaturization degree of the component carriers and reduce warpage of the component carriers, reduce the shifting of the component carriers relative to each other in the z-direction (stacking direction), as well as in a plane perpendicular to the stacking direction (x-direction and y-direction).

A further advantage of the described design is provided for the case in which a shielded metal is used for manufacturing the fastening element. In this case, a lower oxidation of the fastening element and a shielding of the electrical parts of the component carrier can be achieved.

### Description of Exemplary Embodiments

The component carrier assembly comprises at least two component carriers being fastened together by means of the fastening element. The component carrier assembly is therefore a poly-member assembly comprising more members, such as the component carriers, being held together by the fastening element.

According to an embodiment, the fastening element is configured as at least one of the group which consists of a screw, an eyelet and a rivet. This may provide the advantage that established and reliable mechanical connectors can be directly implemented. The fastening element is however not limited to the ones listed above, but may include also other types of fastening elements such as, for example, a bolt, a spring pin, a split pin or a tapered pin.

According to an embodiment, the fastening element extends along or in a direction parallel to the stacking direction. In such a way, it may be possible to better compensate the surface irregularities of the component carriers, due to the forces in the z-direction exerted by surface irregularities.

According to an embodiment, the fastening element is configured to be releasable. In this case, the fastening element does not form a permanent fixture that fixes together the first component carrier and the second component carrier. Thereby, the component carrier assembly designed may be adapted in a flexible manner.

It may however also be the case, that the fastening element is a non-releasable, and therefore permanent fixing feature, as in the case of a rivet. This may provide a permanent stability.

According to an embodiment, the fastening element is configured to maintain the first component carrier and the second component carrier at a predefined distance from one another. This might be in particular the case when an interposer, such as a dielectric layer, e.g. a prepreg layer, is placed between the first component carrier and the second component carrier. Hence, further layer structures may be efficiently fixed between component carriers in the assembly.

According to an embodiment, the mechanical element is configured to push the first and the second component carriers one against the other. This measure may allow for an especially robust configuration. In this case, the first component carrier and the second component carrier are fixed against each other by the fastening element. This is the case, when an upper surface of the first component carrier or of the second component carrier contacts directly with a lower surface of the second component carrier or of the first component carrier, when seen along the z-direction.

According to an embodiment, the fastening element comprises a metallic material. In one example, the metallic material is a shielded metal. A fastening element made of or comprising a shielded metal provides a high mechanical stability of the fastening element, while minimizing the risk of interfering with the signal transmission in the first component carrier and/or in the second component carrier. In such a way there is no connection created by the fixture element and shielding is provided against signal losses and conductivity of the fixture elements is repelled inside the component carrier assembly. Also, the fastening element is less prone to oxidation and corrosion problems, if it is made of or comprises a shielded metal.

According to an embodiment, the fastening element comprises a non-metallic material, in particular one of plastic, ceramic, glass (or component carrier materials such as fully cured resin). A non-metallic material for the fastening element may advantageously avoid interferences with the signal transmission in the first component carrier and/or in the second component carrier. In another embodiment, the fastening element comprises a metal material which may increase stability. If the fastening element is made of or comprises a non-metallic material, then the fastening element is also not going to undergo oxidation and corrosion, thus improving the quality of the component carrier assembly. Non-metallic fastening elements can be made from at least one of plastics, ceramics or glass.

According to an embodiment, the component carrier assembly further comprises at least one through hole (or a blind hole) extending at least partially through the first component carrier and the second component carrier, wherein the fastening element is arranged at least partially in the through hole.

If a through hole is provided, it is possible to place and remove the fastening element for fixing the first component carrier and the second component carrier together.

It is also possible, that the through hole extends through both, the first component carrier and the second component carrier. In this case it is possible to first align the component carriers and then place the fastening element in the through hole for fixing the component carrier assembly.

According to an embodiment, the through hole is a non-plated through hole, which may also be referred to as NPTH (non-plated through hole). Thus, it is possible to provide a through hole for placing the fastening element by using an established PCB manufacture technique.

The through hole or the blind hole might have slanted, tapered or straight walls.

According to an embodiment, the component carrier assembly further comprises a gap between the fastening element and a sidewall of the through hole. In such a way it is possible to allow adjustment movement of the fastening element during the fabrication process and thus avoid high thermal and residual stresses.

According to an embodiment, the gap is a play tolerance. A play tolerance is a gap between the fastening element and the sidewall of the through hole providing a tolerance fit of the fastening element in the through hole.

According to an embodiment, the gap can be filled with filler material for stabilizing the connection after the component carrier assembly has been assembled. The filler material is preferably a dielectric material, further shielding any interference between the fastening element and the electric signals of the first component carrier and/or of the second component carrier.

According to an embodiment, the first component carrier is of a first component carrier type and the second component carrier is of a second component carrier type, wherein the first component carrier type is different from the second component carrier type. Thus it is possible to manufacture a component carrier assembly having component carriers for different functions.

According to an embodiment, the component carrier type comprises at least one of: a printed circuit board, a printed circuit board panel, a substrate, a substrate panel, a digital board, an analog board, an antenna board.

According to an embodiment, the component carrier assembly further comprises a resin layer structure and/or an interposer layer structure arranged between the first component carrier and the second component carrier.

According to an embodiment, the interposer layer structure is a prepreg layer structure. Thus a dielectric, electrically insulating material layer is placed between the first component carrier and the second component carrier.

According to an embodiment, the resin layer structure and/or the interposer structure configured as a mechanical buffer. A mechanical buffer may be a structure conferring flexibility to the component carrier assembly and providing stress release to the first component carrier and to the second component carrier. Thus, the residual stresses occurred during the manufacturing of the component carrier assembly may be advantageously absorbed by the mechanical buffer.

According to an embodiment, the fastening element extends through the resin layer structure and/or interposer layer structure.

According to an embodiment, the component carrier assembly further comprises a via extending through the resin layer structure and/or the interposer layer structure. A via may be an electrical connection between the first component carrier and the second component carrier or any two electrically conductive layers. A via can be a through-hole via, a buried via, and/or a blind via. The via might be filled with conductive material, such as copper. If the via is filled with a conductive material, both the electrical conductivity and the thermal conductivity of the assembly may be improved.

According to an embodiment, the fastening element has a thermal expansion coefficient along the z-direction in the range 16 to 47 ppm/K.

According to an embodiment, the fastening element has a Young module in the range 3.6 to 250 kN/mm2.

A low Young modulus or a low thermal expansion modulus in the z-direction may provide more stability of the fastening element.

According to an embodiment, the component carrier further comprises a third component carrier, comprising at least one third electrically insulating layer structure and/or at least one third electrically conductive layer structure and arranged above the first component carrier in the z-direction, and a fourth component carrier, comprising at least one fourth electrically insulating layer structure and/or at least one fourth electrically conductive layer structure and arranged below the second component carrier in the z-direction. The component carrier assembly also comprises a further adhesive conductive paste arranged between the first component carrier and the third component carrier and between the second component carrier and the fourth component carrier, respectively, and a further elongated mechanical fastening element. The further fastening element at least partially extends through the first component carrier, the second component carrier, the third component carrier, and the fourth component carrier, and the further fastening element is configured to fix the third component carrier and the fourth component carrier together.

In such a way it is possible to build the component carrier assembly in a modular way, by first assembling the first component carrier and the second component carrier and fixing them together and then by placing the third component carrier above the first component carrier and the fourth component carrier below the second component carrier and fixing them together with the further fastening element.

It is also possible, that the further fastening element is the sole fastening element used in the component carrier assembly. In this case, the further fastening element extends at least partially through the first component carrier, the second component carrier, the third component carrier and the fourth component carrier.

The third component carrier and the fourth component carrier can be stacked with the first component carrier and the second component carrier.

According to an embodiment, the fastening element comprises a body portion and a head portion, wherein the head portion is broader than the body portion.

The first component carrier or the second component carrier might have a first receiving portion, in which the head portion of the fastening element is located when the fastening element fixes the first component carrier and the second component carrier together. In such a way, the component carrier assembly does not require more space for the fastening element.

It can however also be the case, that the head portion of the fastening element juts out of the volume defined by the component carrier assembly, when the fastening element fixes the first component carrier and the second component carrier together. In this case, the fastening element is more accessible.

According to an embodiment, the fastening element also comprises a base portion wherein the base portion is broader than the body portion.

The first component carrier or the second component carrier might have a second receiving portion, in which the base portion of the fastening element is located when the fastening element fixes the first component carrier and the second component carrier together. In such a way, the component carrier assembly does not require more space for the fastening element.

It can however also be the case, that the base portion of the fastening element juts out of the volume defined by the component carrier assembly, when the fastening element fixes the first component carrier and the second component carrier together. In this case, the fastening element is more accessible.

A fastening element comprising both a head portion and a base portion, might comprise the head portion and the base portion to be equal or different to each other. It might also be configured, that both the head portion and the base portion are releasably locked on the body portion, when the fastening element is fixing the first component carrier and the second component carrier with each other. This is for example the case when the body portion is a screw rod and the head portion and the base portion are nuts, which can be releasably screwed onto the rod.

It may however also be the case, that only the head or the base portion is releasably locked onto the body portion, when the fastening element is in its working position fixing the first component carrier and the second component carrier with each other.

Alternatively, the fastening element can comprise a fixed head portion and/or a fixed base portion for locking the fastening element once it is inserted in the through hole and holds the component carriers together. In such a case, the risk for the fastening element to fail or to get loose during operation of the component carrier assembly is reduced. In such case, rivets are preferably used as fastening elements.

According to an embodiment, a plurality of fastening elements is provided.

By using more fastening elements it is possible to distribute the lack of surface flatness over more fastening elements, thus having a more uniform distribution of residual stresses and a lower warpage of the component carrier assembly.

According to an embodiment, the plurality of fastening element may differ in type (e.g. bolt and rivet), form or size. In such a way it is possible to better redistribute forces and loads around the component carrier assembly.

Also, the plurality of the fastening elements may have a variable length along a direction of main extension between 0.1 and 10 mm and a dimension, for example a width or a diameter, in a direction perpendicular to the direction of main extension between 0.1 and 10 mm.

According to an embodiment, the plurality of fastening elements is arranged as an array on the component carrier assembly, when viewed along the z-direction. In an array arrangement, the plurality of fastening elements is arranged in such a way, that regular constant distances between the fastening elements along an x-direction and along a y-direction are observed. If the plurality of fastening elements is arranged in an array, then the distribution of the residual stresses and the lower warpage of the component carrier assembly may be particularly enhanced due to the regularity of the distance between the fastening elements along the x and y directions.

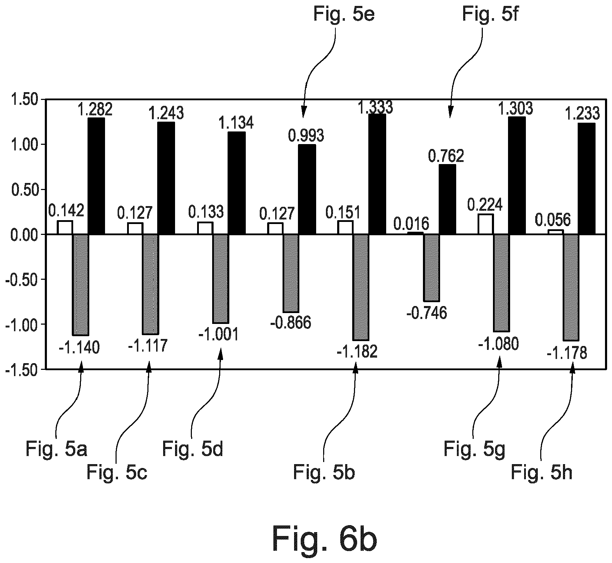

According to an embodiment, the plurality of fastening elements comprises first fastening elements and at least a second fastening element, wherein the first fastening elements are arranged at a peripheral region of the component carrier assembly, when viewed along the z-direction, and wherein the second fastening element is arranged at a center region of the component carrier assembly, when viewed along the z-direction. With this configuration it can be shown that the warpage of the component carrier assembly is reduced to a minimum (see Figure 6b). According to the present document, a peripheral region is a region of the component carrier assembly near to the edges of the component carrier assembly on an xy-plane.

According to an embodiment, the at least one fastening element is arranged in a corner region of the component carrier assembly, when viewed along the z-direction.

According to an embodiment, the plurality of fastening elements is arranged at least partially in the peripheral region of the component carrier assembly, when viewed along the z-direction.

According to an embodiment, the plurality of fastening elements is arranged at least partially at a central region of the component carrier assembly, when viewed along the z-direction.

When the component carrier assembly comprises at least one of the above mentioned features, then the warpage of the component carrier assembly may be efficiently reduced, thereby improving the quality of the component carrier assembly.

According to an embodiment of the method, at least one through hole is formed at least partially through the first component carrier and the second component carrier, wherein the fastening element is at least partially provided in the through hole.

According to an embodiment, the through hole is a non-plated through hole.

According to an embodiment of the method, forming the through hole comprises at least one of mechanical drilling, laser drilling, etching, plasma etching, lithography process or milling, in particular micro-milling.

According to an embodiment of the use claim, a plurality of fastening elements may be used. This may be uniform amongst each other, that is, they may be of the same kind (bolts, rivets, pins), be of the same material, have the same form and the same size. However, it is also possible that the plurality of fastening elements differs in type, material, form or size for granting a better force distribution. For example, there may be fastening elements at the periphery of the component carrier assembly made of a stiffer material than the fastening elements at the center of the carrier assembly.

It is herewith noted, that the apparatus features and the method features are interchangeable, so that the method can comprise all features of the apparatus and the apparatus can comprise all of the features of the method.

In the context of the present application, the term "component carrier" may particularly denote any support structure which is capable of accommodating one or more components thereon and/or therein for providing mechanical support and/or electrical connectivity. In other words, a component carrier may be configured as a mechanical and/or electronic carrier for components. In particular, a component carrier may be one of a printed circuit board, an organic interposer, and an IC (integrated circuit) substrate. A component carrier may also be a hybrid board combining different ones of the above mentioned types of component carriers.

In an embodiment, the component carrier comprises a stack of at least one electrically insulating layer structure and at least one electrically conductive layer structure. For example, the component carrier may be a laminate of the mentioned electrically insulating layer structure(s) and electrically conductive layer structure(s), in particular formed by applying mechanical pressure and/or thermal energy. The mentioned stack may provide a plate-shaped component carrier capable of providing a large mounting surface for further components and being nevertheless very thin and compact. The term "layer structure" may particularly denote a continuous layer, a patterned layer or a plurality of nonconsecutive islands within a common plane.

In an embodiment, the component carrier is shaped as a plate. This contributes to the compact design, wherein the component carrier nevertheless provides a large basis for mounting components thereon. Furthermore, in particular a naked die as example for an embedded electronic component, can be conveniently embedded, thanks to its small thickness, into a thin plate such as a printed circuit board.

In an embodiment, the component carrier is configured as one of the group consisting of a printed circuit board, a substrate (in particular an IC substrate), and an interposer.

In the context of the present application, the term "printed circuit board" (PCB) may particularly denote a plate-shaped component carrier which is formed by laminating several electrically conductive layer structures with several electrically insulating layer structures, for instance by applying pressure and/or by the supply of thermal energy. As preferred materials for PCB technology, the electrically conductive layer structures are made of copper, whereas the electrically insulating layer structures may comprise resin and/or glass fibers, so-called prepreg or FR4 material. The various electrically conductive layer structures may be connected to one another in a desired way by forming holes through the laminate, for instance by laser drilling or mechanical drilling, and by partially or fully filling them with electrically conductive material (in particular copper), thereby forming vias or any other through-hole connection. The filled hole either connects the whole stack, (through-hole connections extending through several layers or the entire stack), or the filled hole connects at least two electrically conductive layers, called via. Similarly, optical interconnections can be formed through individual layers of the stack in order to receive an electro-optical circuit board (EOCB). Apart from one or more components which may be embedded in a printed circuit board, a printed circuit board is usually configured for accommodating one or more components on one or both opposing surfaces of the plate-shaped printed circuit board. They may be connected to the respective main surface by soldering. A dielectric part of a PCB may be composed of resin with reinforcing fibers (such as glass fibers).

In the context of the present application, the term "substrate" may particularly denote a small component carrier. A substrate may be a, in relation to a PCB, comparably small component carrier onto which one or more components may be mounted and that may act as a connection medium between one or more chip(s) and a further PCB. For instance, a substrate may have substantially the same size as a component (in particular an electronic component) to be mounted thereon (for instance in case of a Chip Scale Package (CSP)). In another embodiment, the substrate may be substantially larger than the assigned component (for instance in a flip chip ball grid array, FCBGA, configuration). More specifically, a substrate can be understood as a carrier for electrical connections or electrical networks as well as component carrier comparable to a printed circuit board (PCB), however with a considerably higher density of laterally and/or vertically arranged connections. Lateral connections are for example conductive paths, whereas vertical connections may be for example drill holes. These lateral and/or vertical connections are arranged within the substrate and can be used to provide electrical, thermal and/or mechanical connections of housed components or unhoused components (such as bare dies), particularly of IC chips, with a printed circuit board or intermediate printed circuit board. Thus, the term "substrate" also includes "IC substrates". A dielectric part of a substrate may be composed of resin with reinforcing particles (such as reinforcing spheres, in particular glass spheres).

The substrate or interposer may comprise or consist of at least a layer of glass, silicon (Si) and/or a photoimageable or dry-etchable organic material like epoxy-based build-up material (such as epoxy-based build-up film) or polymer compounds (which may or may not include photo- and/or thermosensitive molecules) like polyimide or polybenzoxazole.

In an embodiment, the at least one electrically insulating layer structure comprises at least one of the group consisting of a resin or a polymer, such as epoxy resin, cyanate ester resin, benzocyclobutene resin, bismaleimide-triazine resin, polyphenylene derivate (e.g. based on polyphenylether PPE), polyimide (PI), polyamide (PA), liquid crystal polymer (LCP), polytetrafluoroethylene (PTFE) and/or a combination thereof. Reinforcing structures such as webs, fibers, spheres or other kinds of filler particles, for example made of glass (multilayer glass) in order to form a composite, could be used as well. A semi-cured resin in combination with a reinforcing agent, e.g. fibers impregnated with the above-mentioned resins is called prepreg. These prepregs are often named after their properties e.g. FR4 or FR5, which describe their flame retardant properties. Although prepreg particularly FR4 are usually preferred for rigid PCBs, other materials, in particular epoxy-based build-up materials (such as build-up films) or photoimageable dielectric materials, may be used as well. For high frequency applications, high-frequency materials such as polytetrafluoroethylene, liquid crystal polymer and/or cyanate ester resins, may be preferred. Besides these polymers, low temperature cofired ceramics (LTCC) or other low, very low or ultra-low DK materials may be applied in the component carrier as electrically insulating structures.

In an embodiment, the at least one electrically conductive layer structure comprises at least one of the group consisting of copper, aluminum, nickel, silver, gold, palladium, tungsten, magnesium , carbon, (in particular doped) silicon, titanium, and platinum. Although copper is usually preferred, other materials or coated versions thereof are possible as well, in particular coated with supra-conductive material or conductive polymers, such as graphene or poly(3,4-ethylenedioxythiophene) (PEDOT), respectively.

The at least one component can be selected from a group consisting of an electrically non-conductive inlay, an electrically conductive inlay (such as a metal inlay, preferably comprising copper or aluminum), a heat transfer unit (for example a heat pipe), a light guiding element (for example an optical waveguide or a light conductor connection), an electronic component, or combinations thereof. An inlay could be for instance a metal block, with or without an insulating material coating (IMS-inlay), which could be either embedded or surface mounted for the purpose of facilitating heat dissipation. Suitable materials are defined according to their thermal conductivity, which should be at least 2 W/mK. Such materials are often based, but not limited to metals, metal-oxides and/or ceramics as for instance copper, aluminium oxide (Al2O3) or aluminum nitride (AIN). In order to increase the heat exchange capacity, other geometries with increased surface area are frequently used as well. Furthermore, a component can be an active electronic component (having at least one p-n-junction implemented), a passive electronic component such as a resistor, an inductance, or capacitor, an electronic chip, a storage device (for instance a DRAM or another data memory), a filter, an integrated circuit (such as field-programmable gate array (FPGA), programmable array logic (PAL), generic array logic (GAL) and complex programmable logic devices (CPLDs)), a signal processing component, a power management component (such as a field-effect transistor (FET), metal-oxide-semiconductor field-effect transistor (MOSFET), complementary metal-oxide-semiconductor (CMOS), junction field-effect transistor (JFET), or insulated-gate field-effect transistor (IGFET), all based on semiconductor materials such as silicon carbide (SiC), gallium arsenide (GaAs), gallium nitride (GaN), gallium oxide (Ga2O3), indium gallium arsenide (InGaAs), indium phosphide (InP) and/or any other suitable inorganic compound), an optoelectronic interface element, a light emitting diode, a photocoupler, a voltage converter (for example a DC/DC converter or an AC/DC converter), a cryptographic component, a transmitter and/or receiver, an electromechanical transducer, a sensor, an actuator, a microelectromechanical system (MEMS), a microprocessor, a capacitor, a resistor, an inductance, a battery, a switch, a camera, an antenna, a logic chip, and an energy harvesting unit. However, other components may be embedded in the component carrier. For example, a magnetic element can be used as a component. Such a magnetic element may be a permanent magnetic element (such as a ferromagnetic element, an antiferromagnetic element, a multiferroic element or a ferrimagnetic element, for instance a ferrite core) or may be a paramagnetic element. However, the component may also be a IC substrate, an interposer or a further component carrier, for example in a board-in-board configuration. The component may be surface mounted on the component carrier and/or may be embedded in an interior thereof. Moreover, also other components, in particular those which generate and emit electromagnetic radiation and/or are sensitive with regard to electromagnetic radiation propagating from an environment, may be used as component.

In an embodiment, the component carrier is a laminate-type component carrier. In such an embodiment, the component carrier is a compound of multiple layer structures which are stacked and connected together by applying a pressing force and/or heat.

After processing interior layer structures of the component carrier, it is possible to cover (in particular by lamination) one or both opposing main surfaces of the processed layer structures symmetrically or asymmetrically with one or more further electrically insulating layer structures and/or electrically conductive layer structures. In other words, a build-up may be continued until a desired number of layers is obtained.

After having completed formation of a stack of electrically insulating layer structures and electrically conductive layer structures, it is possible to proceed with a surface treatment of the obtained layers structures or component carrier.

In particular, an electrically insulating solder resist may be applied to one or both opposing main surfaces of the layer stack or component carrier in terms of surface treatment. For instance, it is possible to form such a solder resist on an entire main surface and to subsequently pattern the layer of solder resist so as to expose one or more electrically conductive surface portions which shall be used for electrically coupling the component carrier to an electronic periphery. The surface portions of the component carrier remaining covered with solder resist may be efficiently protected against oxidation or corrosion, in particular surface portions containing copper.

It is also possible to apply a surface finish selectively to exposed electrically conductive surface portions of the component carrier in terms of surface treatment. Such a surface finish may be an electrically conductive cover material on exposed electrically conductive layer structures (such as pads, conductive tracks, etc., in particular comprising or consisting of copper) on a surface of a component carrier. If such exposed electrically conductive layer structures are left unprotected, then the exposed electrically conductive component carrier material (in particular copper) might oxidize, making the component carrier less reliable. A surface finish may then be formed for instance as an interface between a surface mounted component and the component carrier. The surface finish has the function to protect the exposed electrically conductive layer structures (in particular copper circuitry) and enable a joining process with one or more components, for instance by soldering. Examples for appropriate materials for a surface finish are Organic Solderability Preservative (OSP), Electroless Nickel Immersion Gold (ENIG), Electroless Nickel Immersion Palladium Immersion Gold (ENIPIG), Electroless Nickel Electroless Palladium Immersion Gold (ENEPIG), gold (in particular hard gold), chemical tin (chemical and electroplated), nickel-gold, nickel-palladium, etc. Also nickel-free materials for a surface finish may be used, in particular for high-speed applications. Examples are ISIG (Immersion Silver Immersion Gold), and EPAG (Eletroless Palladium Autocatalytic Gold).

### Brief Description of the Drawings

The aspects defined above and further aspects of the invention are apparent from the examples of embodiment to be described hereinafter and are explained with reference to these examples of embodiment.
**Figure 1** illustrates a side view of a component carrier assembly according to an exemplary embodiment of the present invention.
**Figures 2a** and **2b** illustrate a section view of a component carrier assembly according to another exemplary embodiment of the present invention.
**Figure 3** illustrates an isometric view of a component carrier assembly according to an embodiment of the present invention.
**Figure 4** illustrates the layer structure of a first component carrier, a second component carrier and the resulting component carrier assembly according to an embodiment of the present invention.
**Figures 5a** to **5h** show different possibilities of placing a plurality of fastening elements in a component carrier assembly having the layer structure of **Figure 4****.**
**Figures 6a** and **6b** illustrate the warpage distribution over an xy-plane of the assembly **(****Figure 6a****)** and the total warpage **(****Figure 6b****)** for assemblies having the layer structure of **Figure 4** and the plurality of fastening elements placed according to **Figures 5a** to **5h****.**
**Figure 7** illustrates a component carrier assembly according to a further embodiment.
**Figures 8a, 8b** and **8c** illustrate the total warpage for a first circuit board **(****Figure 8a****),** a second circuit board **(****Figure 8b****)** and an assembly comprising the first circuit board and the second circuit board **(****Figure 8c****)** from the prior art, where no fastening elements are used.

### Detailed Description of the Drawings

The illustrations in the drawings are schematic. In different drawings, similar or identical elements are provided with the same reference signs.

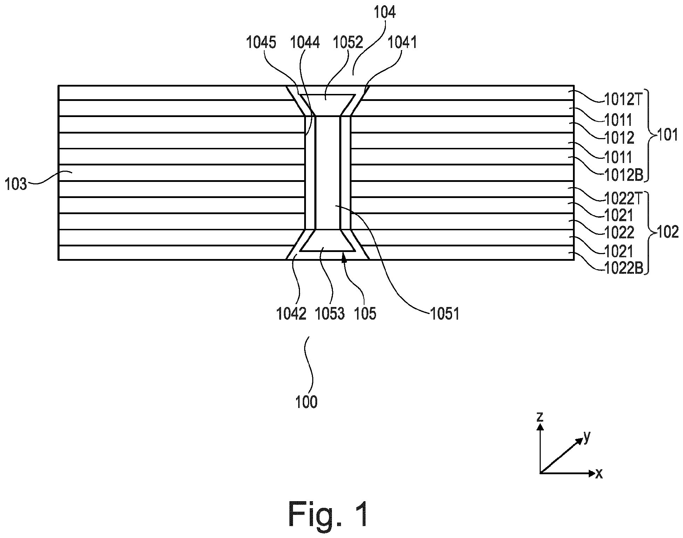

**Figure 1** illustrates a component carrier assembly 100 according to an exemplary embodiment of the invention.

The assembly 100 comprises a first component carrier 101, having first electrically insulating layer structures 1012 and first electrically conducting layer structures 1011. The topmost layer structure, in **Figure 1** an electrically insulating layer structure 1012T, and the bottommost layer structure, in **Figure 1** an electrically insulating layer structure 1012B, might comprise a surface finish.

The assembly 100 comprises furthermore a second component 102, having a second electrically insulating layer structure 1022 and a second electrically conducting layer structure 1021. Also for the second component carrier 102, the topmost layer structure, in **Figure 1** an electrically insulating layer structure 1022T, and the bottommost layer structure, in **Figure 1** an electrically insulating layer structure 1022B, might comprise a surface finish.

The first component carrier 101 and the second component carrier 102 can be of any type, such as, but not limited to, a PCB, a PCB panel, a substrate, a substrate panel, a digital board, an analog board, an antenna board, an integrated circuit, an active electronic component or a passive electronic component. The first component carrier 101 and the second component carrier 102 need not to be of the same type but can be of two different types. For example, the first component carrier and the second component carrier can be any of a printed circuit board, a printed circuit board panel, a substrate, a substrate panel, a digital board, an analog board, an antenna board. For the case in which the first component carrier 101 and the second component carrier 102 are of different types, then they can implement different functionalities, such as an antenna board and a printed circuit board.

The first component carrier 101 and the second component carrier 102 are stacked the one on top of the other, wherein between the first component carrier 101 and the second component carrier 102 there is an adhesive conductive paste, which might be a layer, 103, which is provided in a layer form.

A through hole 104 having sidewalls 1044 extends through the first component carrier 101 and the second component carrier 102. The through hole 104 can be a non-plated through hole.

The assembly 100 further comprises an elongated mechanical fastening element 105. The fastening element 105 has a body portion 1051 and a head portion 1052, wherein the head portion 1052 is broader than the body portion 1051. Furthermore, the fastening element 105 also comprises a base portion 1053. In the present embodiment, the base portion 1053 can be releasable locked onto the body portion 1051 of the fastening element 105. In the present embodiment, the base portion 1053 is broader than the body portion 1051. It can however also be the case, that the base portion 1053 is not broader than the body portion 1051.

It can also be the case, that also the head portion 1052 is releasable locked onto the body portion 1051. Particularly advantageous is when the head portion 1052 and the base portion 1053 are identical and they can both be releasably locked onto the body portion 1051 is the same way. This is for example the case when the body portion 1051 is a screw rod and the head portion 1052 and the base portion 1053 are nuts, which can be screwed onto the screw rod to form a bolt.

In the present embodiment, the fastening element 105 comprises a shielded metal, that is a metallic material. The fastening component 105 may however also comprise a non-metallic material, such as plastic, ceramic or glass.

In the present embodiment, the fastening element 105 is a bolt element comprising a screw rod on which two nuts, forming the head portion 1052 and the base portion 1053, are releasably screwed. The fastening element can however also be of any other kind such as, but not limited to, an eyelet, a rivet, a spring pin, a snap pin or a tapered pin.

The fastening element 105 is arranged in the through hole 104, wherein the through hole 104 comprises a first receiving portion 1041 for the head portion 1052 of the fastening element 105. Analogously, the through hole 104 comprises a second receiving portion 1042 for the base portion 1053. In the present embodiment, neither the head portion 1052 nor the base portion 1053 of the fastening element 105 are jutting out of the assembly 100.

When inserted into the trough hole 104 and after locking the base portion 1053 to the body portion 1051, the fastening element 105 fixes the first component 101 and the second component 102 together.

In its working position, there is a gap 1045 between the fastening element 105 and the through hole 104. In particular, the gap 1045 is between the head portion 1052 and the first receiving portion 1041, between the body portion 1051 and the sidewall 1044 of the through hole 104 and between the base portion 1053 and the second receiving portion 1042.

The gap 1045 is a play tolerance and allows a relative movement of the first component carrier 101 and the second component carrier during manufacturing process, thus preventing residual stress, deformation and warpage.

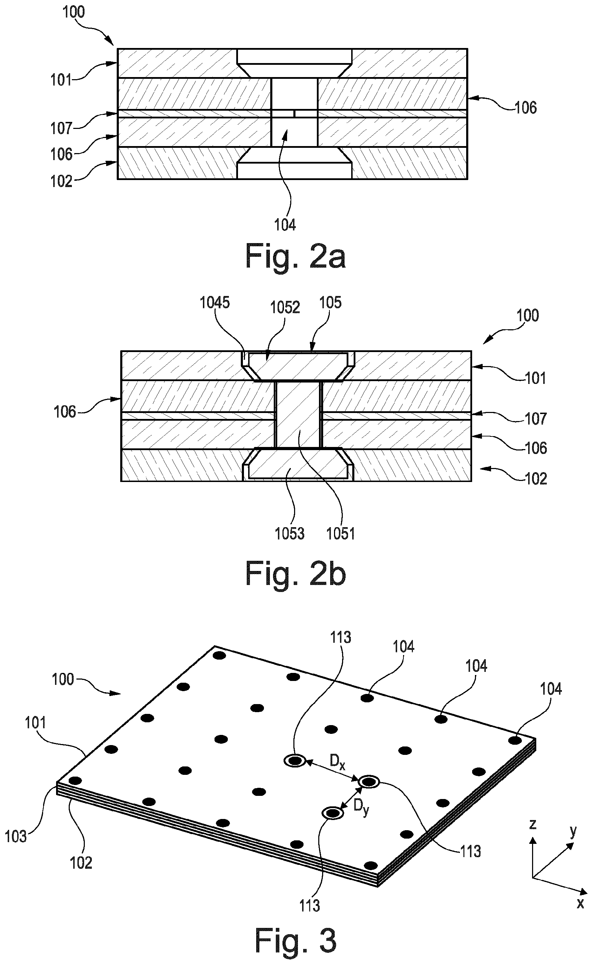

**Figure 2a** illustrates a component carrier assembly 100 according to another embodiment of the invention. In **Figure 2a** the first component carrier 101 and the second component carrier 102 are not directly stacked one on top of the other. Rather, a first resin layer structure 106 is stacked on top of the second component carrier 102 and the first component carrier 101 is stacked on top of a second resin layer structure 106. Between the two resin layer structures 106 there is an interposer layer structure 107. The through hole 104 extends in the embodiment according to **Figure 2a** through the resin layer structures 106 and the interposer structure 107, so that the fastening element 105 also extends through the resin layer structures 106 and the interposer layer structure 107 to fix them as well to the first component carrier 101 and the second component carrier 102 for improving the stability of the whole assembly 100.

**Figure 2b** illustrates the assembly 100 of **Figure 2a****,** wherein the fastening element 105 is inserted in the through hole 104 and both the head portion 1052 and the base portion 1053 are locked, so that the fastening element 105 fixes all components of the assembly 100 together.

**Figure 3** shows an isometric view of the assembly 100 with the first component carrier 101, the second component carrier 102, wherein the first component carrier 101 is stacked on top of the second component carrier 102, and the adhesive conductive paste 103 between the first component carrier 101 and the second component carrier 102.

In the embodiment of **Figure 3** there are a plurality of through holes 104 for allowing a plurality of fastening elements 113 to be used for fixing the first component carrier 101 and the second component carrier 102 to one another. In the embodiment of **Figure 3****,** the plurality of fastening elements 113 is arranged as an array, meaning that the fastening elements 113 are placed at regular and constant distances along the x-direction (Dx) and along the y-direction (Dy). Dx and Dy can be equal or different from each other.

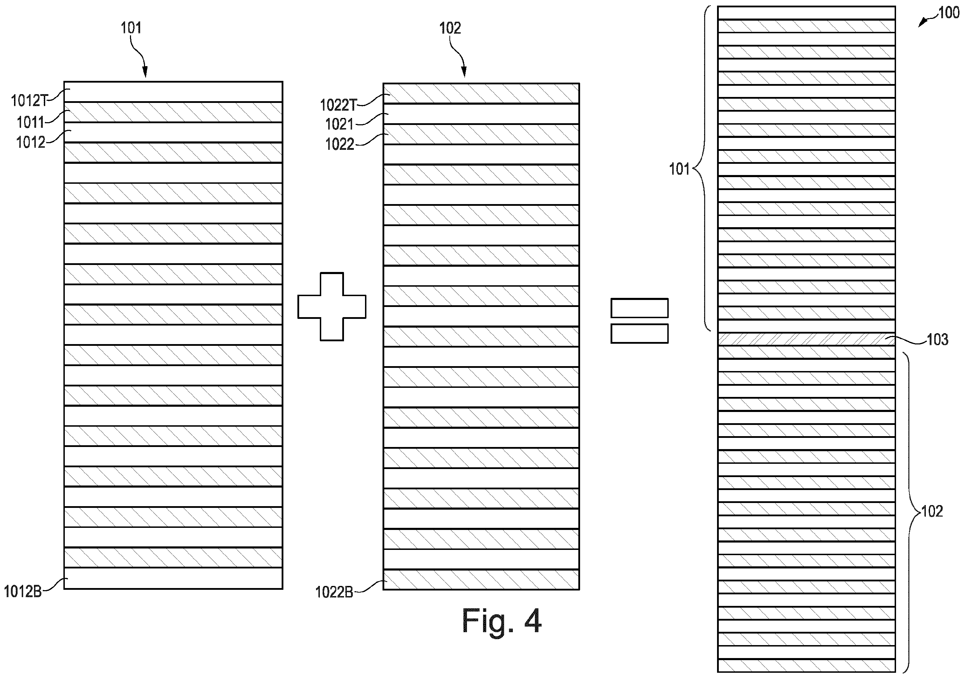

**Figure 4** illustrates a composition of an assembly 100 according to an embodiment of the invention. A first component carrier 101 has a plurality of first electrically conducting layer structures 1011 and first electrically insulating layer structures 1012. The first component carrier 101 comprises twelve first electrically conducting layer structures 1011 and thirteen first electrically insulating layer structures 1012. A second component carrier 102 has also a plurality of second electrically conducting layer structures 1021 and second electrically insulating layer structures 1022. The second component carrier 102 comprises twelve second electrically conducting layer structures 1021 and thirteen second electrically insulating layer structures 1022. The first component carrier 101 and the second component carrier 102 are stacked the one on top of the other, whereby between the first component carrier 101 and the second component carrier 102 an adhesive conductive paste 103 in form a layer is arranged.

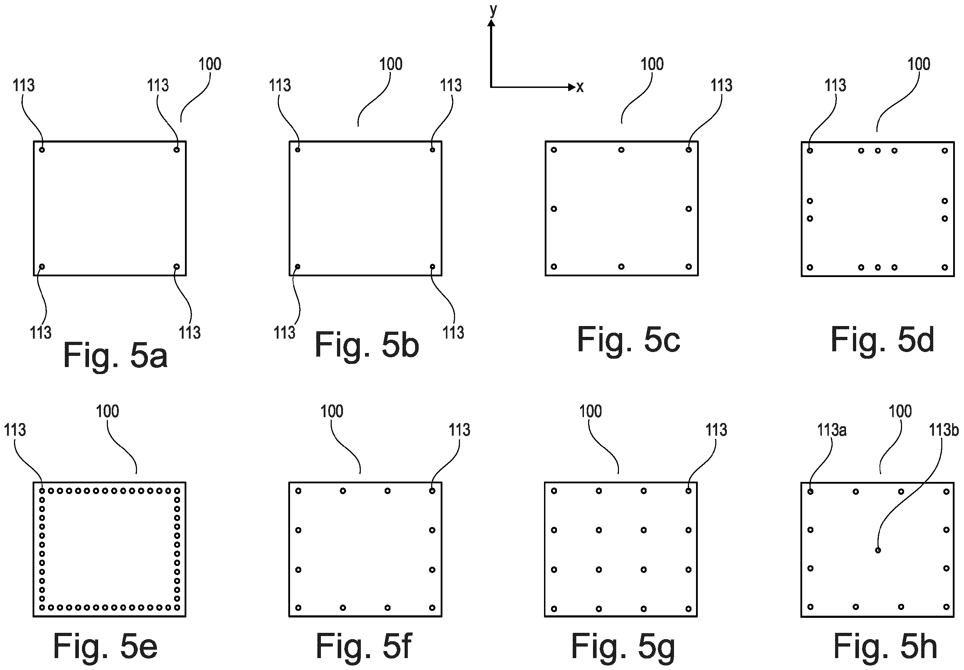

**Figures 5a** to **5h** illustrate, in a view on the xy-plane, different configurations of the assembly 100 for a plurality of fastening elements 113. In the embodiment of **Figure 5a** and in the embodiments of **Figure 5c** to **Figure 5h****,** all the plurality of fastening elements 113 are configured as bolts with a diameter of 10 mm. In **Figure 5b** the plurality of fastening elements are bolts with a diameter of 4 mm.

In **Figure 5a** the plurality of the fastening elements 113 are configured as four bolts arranged at the four corner regions of the assembly 100. Also in **Figure 5b** the plurality of fastening elements 113 are configured as four bolts arranged at the four corner regions of the assembly 100, whereby in the case of **Figure 5b** the diameter of the bolts is 4 mm instead of 10 mm.

In **Figure 5c** the plurality of the fastening elements 113 is arranged at a peripheral region of the assembly 100, meaning that the plurality of the fastening elements 113 is arranged along the perimetral edges of the assembly 100. In the embodiment according to **Figure 5c****,** there is a total of eight fastening elements, four of which are arranged at the four corner regions of the assembly 100 and the remaining four are arranged at each middle point of the four perimetral edges of the assembly 100. In **Figure 5c****,** therefore, the distance between the plurality of fastening elements 113 arranged at the peripheral region of the assembly 100 remains constant.

In **Figure 5d** the plurality of the fastening elements 113 is arranged at a peripheral region of the assembly 100. In the embodiment according to **Figure 5d****,** there is a total of fourteen fastening elements, four of which are arranged at the four corner regions of the assembly 100. The remaining ten fastening elements are arranged irregularly at the peripheral regions of the assembly 100: three fastening elements are arranged at each the lower and the upper edge, along the y-direction, around the middle point of the respective edge and two fastening elements are arranged at each the left and the right edge, along the x-direction, around the middle point of the respective edge.

In **Figure 5e** the plurality of fastening elements 113 is arranged at a peripheral region of the assembly 100. In the embodiment according to **Figure 5e** there are fifty six fastening elements, which are equally distributed at constant distances along the perimetral edges of the assembly 100.

In **Figure 5f** the plurality of the fastening elements 113 is arranged at a peripheral region of the assembly 100, meaning that the plurality of the fastening elements 113 is arranged along the perimetral edges of the assembly 100. In the embodiment according to **Figure 5f****,** there is a total of twelve fastening elements, four of which are arranged at the four corner regions of the assembly 100 and the remaining eight are arranged at the four perimetral edges of the assembly 100. In **Figure 5f****,** the distance between the plurality of fastening elements 113 arranged at the peripheral region of the assembly 100 remains constant.

In **Figure 5g** the plurality of the fastening elements 113 is arranged as an array. The array has four rows and four columns. The distance along the x-direction and the distance along the y-direction between neighboring fastening elements is constant.

In **Figure 5h** the plurality of the fastening element 113 comprises twelve first fastening elements 113a and a second fastening element 113b, wherein the first fastening elements are arranged at a peripheral region of the assembly 100 and the second fastening element 113b is arranged at a central region of the assembly. In the embodiment of **Figure 5h** the first fastening elements 113a are arranged at a regular constant distance the one from the other. It may however be the case, that the distance between the first fastening elements varies. Although in the embodiment according to **Figure 5h** only one second fastening element 113b is provided, more second fastening elements can be present for improving the fixing of the elements forming the assembly 100 and thus reduce the residual stresses and the warpage of the assembly 100.

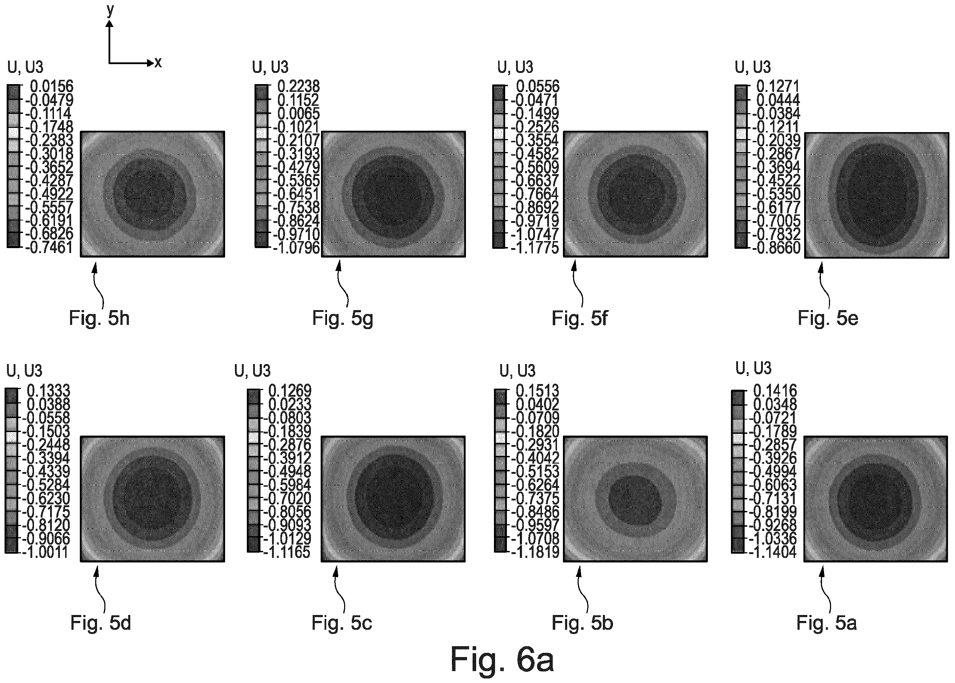

**Figures 6a** and **6b** illustrate graphs representing the warpage distribution over the assembly **(****Figure 6a**), in mm, and the total warpage **(****Figure 6b****)** for the different assemblies 100 represented in **Figures 5a** to **5h** and by considering assemblies having a structure as the one disclosed in **Figure 4****.** In **Figure 6b** the white bars represent the minimum warpage, the gray bars the maximum warpage and the black bars the total warpage. As it can be seen from the results, the positive maximum warpage is achieved at the corner regions of the assembly 100 and this cannot be reduced significantly with more bolt connections at the peripheral regions. The maximum minimum warpage is achieved at the center of the assembly 100.

From **Figure 6a** and **6b** it is clear, that the best results are achieved when first fastening elements 113a is arranged at the peripheral region of the assembly, when viewed from a z-direction, and the one second fastening element 113b is arranged at the center region of the component carrier, when viewed along the z-direction.

**Figure 7** illustrates an exemplary embodiment of the invention, according to which the assembly 100 comprises also a central component carrier 114 a third component carrier 109 and a fourth component carrier 110. Each of the third component carrier 109 and the fourth component carrier 110 have at least one third and at least one fourth electrically insulating layer structure and/or at least one third and at least one fourth electrically conductive layer structure (here not shown).

The assembly 100 has the following structure: the third component carrier 109 is stacked on the first component carrier 101, which is stacked on the central component carrier 114, which is stacked on the second component carrier 102, which is stacked on the fourth component carrier 110.

Between the third component carrier 109 and the first component carrier 101 and between the second component carrier 102 and the fourth component carrier 110 there is a further adhesive conductive paste 111, which is provided as a layer, to promote adhesion and conduction of the electrical signals between the layers.

Between the first component carrier 101 and the central component carrier 114 and between the central component carrier 114 and the second component carrier there is the adhesive conductive paste (here not shown) to promote adhesion and conduction of the electric signal between the layers. Furthermore, between the first component carrier 101 and the central component carrier 114 and between the central component carrier 114 and the second component carrier 102 there is a resin layer structure 106, in which vias 108 are present. The vias 108 might be filled with electrically conductive material.

The first component carrier 101, the second carrier 102 and the central component carrier 114 are fixed together by means of two fastening elements 105.

The third component carrier 109 and the fourth component carrier 110 are fixed together by means of further fastening elements 112. The further fastening elements 112 may comprise the same material and be of the same type of the fastening elements 105. In the embodiment of **Figure 7** both the fastening elements 105 and the further fastening elements 112 are bolt elements having a body portion 1051, 1121, a head portion 1052, 1122 and a base portion 1053, 1123. Both the head portions 1052, 1122 and the base portions 1053, 1123 are broader than the respective body portions 1051, 1121 and the are located in first receiving portions 1041 and second receiving portions 1042 of the through holes 104. The head portions 1052, 1122 and the base portions 1053, 1123 are nuts that can be screwed on the body portions 1051, 1121, which are formed as screw rods.

**Figures 8a, 8b** and **8c** show the total warpage for a first circuit board **(****Figure 8a****),** a second circuit board **(****Figure 8c****)** and an assembly comprising the first circuit board and the second circuit board **(****Figure 8c****)** of the prior art, when no fastening elements are used.

By a comparison of **Figure 6b** with **Figures 8a, 8b** and **8c** it is evident how the warpage can be significantly reduced when using the described fixing elements. In particular, the total warpage of the assembly without the fixing elements is 2.471 **(****Figure 8c****)** and the total warpage of the assembly with fixing elements is between 1.333 and 0.762 mm **(Figure 7b).**

It should be noted that the term "comprising" does not exclude other elements or steps and the "a" or "an" does not exclude a plurality. Also elements described in association with different embodiments may be combined.

It should also be noted that reference signs in the claims shall not be construed as limiting the scope of the claims.

Implementation of the invention is not limited to the preferred embodiments shown in the figures and described above. Instead, a multiplicity of variants are possible which use the solutions shown and the principle according to the invention even in the case of fundamentally different embodiments.

### Reference signs

- 100: component carrier assembly
- 101: first component carrier
- 1011: first electrically conductive layer structure
- 1012: first electrically insulating layer structure
- 1012T: first electrically insulating layer structure with surface finish
- 1012B: first electrically inculating layer structure with surface finish
- 102: second component carrier
- 1021: second electrically conductive layer structure
- 1022: second electrically insulating layer structure
- 1022T: second electrically insulating layer structure with surface finish
- 1022B: second electrically insulating layer structure with surface finish
- 103: adhesive conductive paste
- 104: through hole
- 1041: first receiving portion
- 1042: second receiving portion
- 1044: sidewall
- 1045: gap
- 105: fastening element
- 1051: body portion
- 1052: head portion
- 1053: base portion
- 106: resin layer structure
- 107: interposer layer structure
- 108: via
- 109: third component carrier
- 110: fourth component carrier
- 111: further adhesive conductive paste
- 112: further fastening element
- 1121: body portion
- 1122: head portion
- 1123: base portion
- 113: plurality of fastening elements
- 113a: first fastening element
- 113b: second fastening element
- 114: central component carrier

## Claims

1. A component carrier assembly (100), comprising:
a first component carrier (101) comprising at least one first electrically insulating layer structure (1012) and/or at least one first electrically conductive layer structure (1011);
a second component carrier (102), comprising at least one second electrically insulating layer structure (1022) and/or at least one second electrically conductive layer structure (1021),
wherein the first component carrier (101) and the second component carrier (102) are stacked;
an adhesive conductive paste (103) arranged between the first component carrier (101) and the second component carrier (102); and
at least an elongated mechanical fastening element (105),
wherein the fastening element (105) at least partially extends through the first component carrier (101) and the second component carrier (102), and
wherein the fastening element (105) is configured to fix the first component carrier (101) and the second component carrier (102) together.

2. The component carrier assembly (100) according to claim 1, further comprising:
at least one through hole (104), in particular a non-plated through hole (104), extending at least partially through the first component carrier (101) and the second component carrier (102),
wherein the fastening element (105) is arranged at least partially in the through hole (104).

3. The component carrier assembly (100) according to claim 2, further comprising:
a gap (1045), in particular a play tolerance, between the fastening element (105) and a sidewall (1044) of the through hole (104).

4. The component carrier assembly (100) according to any one of the preceding claims,
wherein the first component carrier (101) is of a first component carrier type;
wherein the second component carrier (102) is of a second component carrier type; and
wherein the first component carrier type is different from the second component carrier type.

5. The component carrier assembly (100) according to claim 4,
wherein the component carrier type comprises at least one of: a printed circuit board, a printed circuit board panel, a substrate, a substrate panel, a digital board, an analog board, an antenna board.

6. The component carrier assembly (100) according to any one of the preceding claims, further comprising:
a resin layer structure (106) and/or an interposer layer structure (107), in particular a prepreg layer structure, arranged between the first component carrier (101) and the second component carrier (102),
in particular wherein the fastening element (105) extends through the resin layer structure (106) and/or interposer layer structure (107).

7. The component carrier assembly (100) according to claim 6, further comprising:
a via (108), wherein the via (108) extends through the resin layer structure (106) and/or the interposer layer structure (107).

8. The component carrier assembly (100) according to any one of the preceding claims,
wherein the fastening element (105) has a thermal expansion coefficient along the z-direction in the range 16 to 47 ppm/K; and/or
wherein the fastening element (105) has a Young module in the range 3.6 to 250 kN/mm2; and/or
wherein the fastening element (105) comprises a metallic material, in particular a shielded metal or wherein the fastening element (105) comprises a non-metallic material, in particular one of plastic, ceramic or glass; and/or
wherein the fastening element (105) is configured as at least one of the group which consists of a screw, an eyelet, a rivet.

9. The component carrier assembly (100) according to any of the preceding claims, further comprising:
a third component carrier (109), comprising at least one third electrically insulating layer structure and/or at least one third electrically conductive layer structure, and arranged on the first component carrier (101);
a fourth component carrier (110) comprising at least one fourth electrically insulating layer structure and/or at least one fourth electrically conductive layer structure, and arranged below the second component carrier (102);
a further adhesive conductive paste (111) arranged between the first component carrier (101) and the third component carrier (109) and between the second component carrier (102) and the fourth component carrier (110), respectively; and
a further elongated mechanical fastening element (112),
wherein the further fastening element (112) at least partially extends through the first component carrier (101), the second component carrier (102), the third component carrier (109), and the fourth component carrier (110), and
wherein the further fastening element (112) is configured to fix the third component carrier (109) and the fourth component carrier (110) together.

10. The component carrier assembly (100) according to any one of the preceding claims,
wherein the fastening element (105) comprises a body portion (1051) and a head portion (1052),
wherein the head portion (1052) is broader than the body portion (1051).

11. The component assembly (100) according to any of the preceding claims, wherein a plurality of fastening elements (113) is provided.

12. The component carrier assembly (100) according to claim 11,
wherein the plurality of fastening elements (113) comprises first fastening elements (113a) and at least a second fastening element (113b);
wherein the first fastening elements (113a) are arranged at a peripheral region of the component carrier assembly (100), when viewed along the z-direction, and
wherein the second fastening element (113b) is arranged at a center region of the component carrier assembly (100), when viewed along the z-direction.

13. The component assembly (100) according to any one of the claims 11 or 12, wherein the component assembly (100) comprises at least one of the following features:
the plurality of fastening elements (113) is arranged as an array, when viewed along the z-direction;
the at least one fastening element (113) is arranged in a corner region of the component carrier assembly (100), when viewed along the z-direction;
the plurality of fastening elements (113) is arranged at least partially in the peripheral region of the component carrier assembly (100), when viewed along the z-direction;
the plurality of fastening elements (113) is arranged at least partially at a central region of the component carrier assembly (100), when viewed along the z-direction.

14. A method of manufacturing a component carrier assembly (100), wherein the method comprises:
providing a first component carrier (101), comprising at least one first electrically insulating layer structure (1012) and/or at least one first electrically conductive layer structure (1011);
providing a second component carrier (102), comprising at least one second electrically insulating layer structure (1022) and/or at least one electrically conductive layer structure (1021);
arranging an adhesive conductive paste (103) between the first component carrier (101) and the second component carrier (102);
stacking the first component carrier (101) and the second component carrier (102); and
fixing the first component carrier (101) and the second component carrier (102) together by providing an elongated mechanical fastening element (105) at least partially through the first component carrier (101) and the second component carrier (102).

15. Using an elongated mechanical fastening element (104) to fix together a stack of component carriers (101, 102), that are connected via adhesive conductive paste (103), along the z-direction.
